Europäisches Patentamt

European Patent Office

Office européen des brevets

(11) Publication number : **0 488 705 A1**

# EUROPEAN PATENT APPLICATION

(21) Application number : **91310980.7**

(51) Int. Cl.$^5$ : **G03F 7/038, H05K 3/00**

(22) Date of filing : **28.11.91**

(30) Priority : **30.11.90 JP 337242/90**

(43) Date of publication of application :
**03.06.92 Bulletin 92/23**

(84) Designated Contracting States :
**DE FR GB**

(71) Applicant : **SOMAR CORPORATION**
**11-2, Ginza 4-chome Chuo-ku**
**Tokyo 104 (JP)**

(72) Inventor : **Ogitani, Osamu, 807,**
**Mitsuisengendai Heights**
**1051-2, Oaza-Kamimakuri**
**Koshigaya-shi, Saitama-ken (JP)**
Inventor : **Kawashima, Masao**
**10-10, Tsukakoshi 4-chome**
**Warabi-shi, Saitama-ken (JP)**
Inventor : **Shirose, Toru**
**West-Town 207, 3-45, Ganounishi-machi**
**1-chome**
**Koshigaya-shi, Saitama-ken (JP)**
Inventor : **Fujii, Ryuichi**
**33-8-10-206, Harayama 2-chome**
**Urawa-shi, Saitama-ken (JP)**

(74) Representative : **Allam, Peter Clerk**
**LLOYD WISE, TREGEAR & CO. Norman House**
**105-109 Strand**
**London WC2R 0AE (GB)**

(54) Laminate film having a thermocurable resin layer.

(57)    A laminate film is disclosed which includes a substrate film and a photocurable resin film formed of a photocurable epoxy resin, a photopolymerization catalyst and a phenoxy or butyral resin and supported on one surface of the substrate film. The laminate film is useful for forming an electrically insulating layer over a conducting surface by transference of the photocurable resin film to the conducting surface.

EP 0 488 705 A1

This invention relates to a laminate film suitable for forming an electrically insulating layer over an electrically conducting surface.

In lieu of applying a coating composition for forming a resin layer, such as an electrically insulating layer, over a surface of a substrate, such as an electrically conducting surface of a printed circuit board, there is a proposal to transfer a solid, resin layer from a support to the surface to be coated.

EP-A-0377332 discloses a laminate film composed of a substrate and a photocurable resin layer provided on one surface of the substrate and formed of a photocurable resin composition containing an epoxy resin and a curing agent therefor. In forming an insulating layer over a printed wiring board, the laminate is superposed on the conductive surface with the photocurable resin layer being in contact with the surface. The assembly is then press-bonded at a temperature sufficient to melt the resin layer and then cooled to re-solidify the resin layer. The substrate is then peeled off and the solidified resin layer is heated to cure the resin layer. During the curing stage, the resin layer is melted so that a problem is raised because the top surface of the cured resin layer is undesirably uneven due to the unevenness of the conductive surface.

US-A-4,624,912 discloses a laminate film composed of a substrate and a photocurable resin layer supported on one surface of the substrate. In use, the photocurable resin layer is transferred and bonded to a conductive surface with heating and the transferred layer is then cured by irradiation with an actinic light. This photocurable-type laminate film has been found to encounter a problem that the photocurable resin layer fails to exhibit both suitable flexibility and thermal transferability at the same time. More specifically, when the photocurable layer has good flexibility, then the softening point and/or the viscosity in a molten state is so low that the layer cannot be smoothly transferred to the desired surface or cannot retain its shape during the transferring step. On the other hand, when the photocurable resin is suitably selected so that the photocurable layer shows good shape-retentivity and transferability, then the photocurable resin film is so rigid that cracks are apt to be formed during storage or handling.

The present invention has been made in view of the foregoing problems of the conventional techniques. In accordance with the present invention, there is provided a laminate film comprising a substrate film and a photocurable resin film formed of a photocurable resin composition and supported on one surface of said substrate film, said composition including an epoxy resin, a photopolymerization catalyst and a polymer selected from the group consisting of phenoxy resins having a number average molecular weight of at least 10,000 and butyral resins having a number average molecular weight of at least 10,000, the amount of said polymer being 5-150 parts by weight per 100 parts by weight of said epoxy resin.

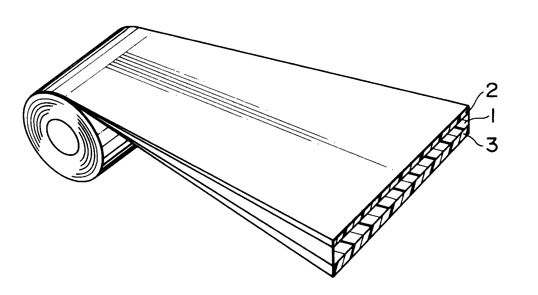

The present invention will now be described in detail below with reference to the accompanying drawing, in which the sole FIGURE is a perspective view schematically illustrating a rolled laminate film according to the present invention.

The laminate film according to the present invention includes a substrate film having supported thereon a photocurable resin film. The substrate film for supporting the photocurable resin film thereon may be a synthetic resin film, a metal film or a metal-deposited resin film. The synthetic resin film may be formed of a polyethylene, a polypropylene, a polystyrene, a polyvinyl chloride, a polyvinylidene chloride, a polyamide, a polyester, a polyimide, a polysulfone, a polyacrylate, a polyether amide or a polycarbonate and preferably has a thickness of 5-250 μm, more preferably 10-125 μm. The metal film may be a copper foil, an aluminum foil or a tin foil. The metal deposited film may be of a type in which silver, aluminum, tin or the like metal is vacuum deposited on a synthetic resin film such as described immediately above. The thickness of the metal film or a vacuum deposited metal layer is generally 0.1-100 μm.

The laminate film of the present invention may be obtained by applying a coating composition to a substrate film, followed by solidification of the resulting coat.

The photocurable resin composition to be coated on the substrate film for the formation of the photocurable resin film should be a liquid at room temperature or at an elevated temperature (generally up to about 120 °C) at which the coating of the composition is carried out. Details of such a composition will now be described below.

The photocurable coating composition for use in the present invention includes an epoxy resin, a photopolymerization catalyst and a polymer selected from phenoxy resins and butyral resins. The epoxy resin to be used in the present invention has two or more epoxy groups in its molecule. Examples of suitable epoxy resins include glycidyl ethers of bisphenol A, bisphenol F, bisphenol AD and brominated bisphenol A; glycidyl ethers of a polyol such as glycerin, 1,6-hexane diol and a polyalkylene oxide; alicyclic epoxy resins; glycidyl esters of polybasic acids such as dimer acid and isophthalic acid; epoxidized polybutadiene obtained by reaction of polybutadiene with peracetic acid; diglycidyl ether of resolcinole; tetraglycidyl ether of bisresolcinole; triglycidy ethers of trihydroxybenzene; triglycidyl isocyanurate; and mixtures thereof.

It is preferred that at least 30 % by weight, more preferably at least 50 % of the epoxy resin be a solid epoxy resin (epoxy resin which is solid at 20 °C) and have a number average molecular weight of at least 300 since the photocurable resin film show suitable fluidity when melted. Thus, a solid epoxy resin or a combination of a solid epoxy resin with a liquid epoxy resin is preferably used in the present invention.

The photo-cationic polymerization catalyst serves as an initiator for the photo-cationic polymerization of the epoxy resin. Examples of the catalysts are as follows:

Diaryliodonium salts:

diphenyliodonium hexafluoroantimonate, diphenyliodonium hexafluorophosphate, 4-chlorophenyliodonium tetrafluoroborate, di(4-methoxyphenyl)iodonium chloride, (4-methoxyphenyl)phenyl-iodonium, etc;

Triarylsulfonium salts:

triphenylsulfonium tetrafluoroborate, triphenylsulfonium hexafluorophosphate, p-(phenylthio)phenyldiphenylsulfonium hexafluoroantimonate, triphenylsulfonium hexafluoroantimonate, 4-chlorophenyldiphenylsulfonium hexafluorophsphate, etc.;

Triarylselenium salts:

triphenylselenium hexafluorophosphate, triphenylselenium hexafluoroantimonate, etc.;

Others:

(2,4-cyclopentadiene-1-yl) (1-methoxyethyl)-benzene -ironhexafluorophosphate, diphenylsulfonium hexafluoroantimonate, dialkylphenylsulfonium hexafluoroantimonate, dialkylphenylsulfonium hexafluorophosphate, 4,4'-bis di(β-hydroxyethoxy)phenylsulfonio phenylsulfide-bis-hexafluoroantimonate, 4,4'-bis[di(β-hydroxyethoxy)phenylsulfonio]phenylsulfide-bis-hexafluorophosphate, etc.

The photopolymerization catalyst may be used in the form of a solution in a solvent such as acetonitrile or propylenecarbonate.

The photocurable resin composition further contains a polymer which is a phenoxy resin or a butyral resin (polyvinyl butyral resin). The polymer serves to impart suitable shape retentivity and transferability to the photocurable resin film at the time of thermal press-bonding (transfering stage). Further, the polymer can impart suitable flexibility to the photocurable resin film. In order to obtain the above effects without adversely affecting the heat-resistance and electrically insulating property inherent to the epoxy resin, it is important that the polymer should have a number average molecular weight of at least 10,000, preferably 10,000-100,000 and should be used in an amount of 5-150 parts by weight, preferably 10-100 parts by weight per 100 parts by weight of the epoxy resin.

The photocurable composition may further contain, if desired, one or more additives such as an organic solvent, a reactive diluent having one epoxy group, a coloring agent, a filler, a defoaming agent and a leveling agent.

Examples of suitable organic solvents include ketones such as acetone, methyl ethyl ketone and methyl isobutyl ketone, alcohols such as methanol, ethanol and isopropanol, cellosolves such as ethylene glycol monomethyl ether, ethylene glycol monoethyl ether and ethylene glycol dialkyl ethers, aromatic hydrocarbons such as benzene, toluene and xylene and halogenated hydrocarbons such as methylene chloride and dichloroethane.

Illustrative of suitable reactive diluents are phenyl glycidyl ether, methylphenyl glycidyl ether and n-butyl glycidyl ether. The coloring agents may be, for example, organic pigments such as phthalocyanine green and phthalocyanine blue and nigrosine. The filler may be, for example, silica, alumina, aluminum hydroxide, calcium carbonate and clay. These fillers may be surface-treated with a silane coupling agent, if desired. The defoaming agent may be, for example, silicone oil. The leveling agent may be, for example, a fluorine-containing surfactant and acrylic copolymers.

The photocurable coating composition may be suitably applied to the substrate film by a roll coating method when the composition is liquid at room temperature or by a hot melt coating method when the composition becomes liquid only upon heating. When the composition contains a solvent, the coating is performed at room temperature and the resulting coat is dried to remove the solvent by vaporization. When the composition contains no solvent, the coating is carried out at an elevated temperature and the resulting coat is cooled for solidification. The thus obtained laminate film is curable by irradiation with an actinic light such as W rays. The thickness of the photocurable resin film is determined in view of the object of use thereof but is generally 10-500 μm, preferably 20-300 μm.

It is important that the photocurable resin film should have such adhesiveness relative to the substrate film that, when the photocurable resin film is bonded to a surface to be coated, such as a conducting surface, the photocurable resin film sticks more strongly to the conducting surface than to the substrate film so that the substrate film may be easily removed by peeling to leave the photocurable resin film on the conducting surface.

Adjustment of the adhesiveness of the photocurable resin film relative to the substrate film can be made by suitably selecting the kind of polymer of the substrate film or by providing, between the photocurable resin film and the substrate film, an intermediate layer containing a substance capable of improving the removability or peelability of the substrate film from the photocurable resin film.

The intermediate layer may be a primer layer formed, for example, of a polyvinyl alcohol resin, a polystyrene resin, an acrylic resin, alcohol-soluble nylon, acetylcellulose or nitrocellulose. A mold releasing agent such as a wax, a higher fatty acid salt or ester, silicone oil, a silane coupling agent, a siloxane compound as mentioned above, a fluorocarbon or a silicone-type or fluorine-type surfactant may also be used for the formation of the intermediate layer. The thickness of the intermediate layer is generally 1-10 μm.

The laminate film according to the present invention may be in the form of a cut sheet or a roll. The latter form is preferred because of easiness in storage and transportation. In this case, it is preferable to provide a peelable, protecting layer over the surface of the photocurable resin film. The protecting layer may be a synthetic resin film, a paper sheet or a laminate sheet having a paper sheet whose one or both surfaces are laminated with a synthetic resin film or films. The previously-described resins for use as the substrate film may be used for forming the protecting layer. Because of the presence of the phenoxy resin or butyral resin, the photocurable resin film does not crack even when the film is wound into a roll.

The laminate film wound in the form of a roll is illustrated in FIGURE. Designated as 1 is a photocurable resin film, as 2 a substrate film and as 3 is a protecting layer. In this case, it is important that the photocurable resin film 1 should have such adhesiveness relative to the substrate film 2 that, when the laminate film is wound to form a roll, the photocurable resin film 1 sticks more strongly to the substrate film 2 than to the protecting layer 3 so that the protecting layer 3 may be easily removed from the photocurable resin film 1 without causing the separation of the photocurable resin film 1 from the substrate film 2.

The prevention of bonding between the top surface of the photocurable resin film and the underside surface of the substrate film during rolled state can also be effected by providing, on the underside surface of the substrate film, an outer layer containing a releasing agent to prevent sticking therebetween. The releasing agent may be, for example, a wax, a higher fatty acid salt or ester, silicone oil, a silane coupling agent, a siloxane compound as mentioned above, a fluorocarbon or a silicone-type or fluorine-type surfactant. Illustrative of suitable releasing agents are dimethylpolysiloxane, methylethylpolysiloxane, methylphenylpolysiloxane, methylvinylpolysiloxane, dimethylpolysiloxane/oxyalkylene copolymers and polysiloxanes modified with long chain alkyl groups.

The laminate film according to the present invention may be suitably used for forming an insulating layer over a conductive surface such as a printed wiring board. When the irradiation is effected through a patterned film and unexposed surfaces are removed by dissolution with a solvent, there is obtainable a patterned insulating layer. Further, the laminate film can be used for forming etching resist or plating resist.

One example of application of the above-described laminate film to the formation of an insulating layer over a conducting surface of a printed wiring board will be described below.

Thermal Press Bonding of Laminate Film:

After removing a protecting layer, if any, the laminate film is superposed on the printed wiring board with the photocurable resin film being in contact with the conducting surface of the board. The superposed board is then subjected to press bonding with heating, preferably by using a vacuum laminating method. During this treatment, the photocurable resin film is heated to a temperature above its softening point and is pressed against the conducting surface so that the softened resin can fill substantially all depressed portions of the conducting surface to form a softened resin layer which is in intimate and close contact with the conducting surface of the printed wiring board. The layer is then cooled and solidified.

Removal of Substrate Film:

The substrate film over the solidified resin layer is then peeled away. Since that the adhesiveness of the solidified layer relative to the substrate film is weaker than that relative to the conducting surface, the substrate film may be easily removed from the solidified layer.

Curing of Solidified Layer:

The solidified layer is then irradiated with UV-rays to cure the photocurable resin. By such a curing treatment, there is formed an insulating layer of the cured epoxy resin excellent in insulating property and in resistance to heat and chemicals. Since the curing is effected by UV irradiation in a short period of time and since the photocurable resin film contains the specific polymer, i.e. phenoxy resin or butyral resin, the photocurable resin film does not flow or change its shape during the curing.

The thus obtained board bearing the insulating layer may be used for preparing multi-layered printed wiring board or may be further processed to effect electromagnetic shielding of the board.

The following examples will further illustrate the present invention.

Example 1

(1) Preparation of Photocurable Resin Composition:

A photocurable resin coating composition was prepared by mixing the following ingredients:

| Ingredients | Amount (parts by weight) |
|---|---|
| Epikote 1001 *1 | 400 |
| Phenototo YP-50 *2 | 100 |
| Epikote 828 *3 | 100 |
| Optomer SP-170 *4 | 24 |
| Methyl ethyl ketone | 400 |

*1: Bisphenol A epoxy resin, weight epoxy equivalent: 450-500, manufactured by Yuka-Shell Epoxy Inc.

*2: Phenoxy resin, manufactured by Toto Kasei Inc.

*3: Bisphenol A epoxy resin, weight epoxy equivalent: 184-194, manufactured by Yuka-Shell Epoxy Inc.

*4: 50 % Solution of 4,4'-bis[di($\beta$-hydroxyethoxy)phenyl-sulfonio]phenylsulfide-bishexafluoroantimonate, manufactured by Asahi Denka Kogyo Inc.

(2) Preparation of Laminate Film:

The above coating composition was applied to one side surface of a polyethylene terephthalate film (substrate film, thickness: 50 μm, width: 250 mm) at 20 °C using a roll coater. The coat was dried at 120 °C to form a photocurable resin layer with a thickness of 25 μm. The coated film was laminated with a polyethylene film (protecting layer) and the laminate was wound into a roll having a construction as shown in the FIGURE. This laminate film was found to show good flexibility and thermo-bonding property after having been stored for 3 months at 25 °C.

(3) Press-Bonding:

The rolled laminate film was drawn and cut into a predetermined length and the protecting layer was removed therefrom. The cut film was superposed on a printed wiring board with the photocurable resin layer being in contact with the wiring pattern-bearing surface of the board. The superposed board was then fed to a vacuum laminator to effect press-bonding of the resin layer on the wiring pattern-bearing surface with heating at 100 °C. After cooling, the substrate film was removed to obtain a wiring board-whose wiring pattern-bearing surface was covered with the photocurable resin layer.

(4) Curing:

The photocurable resin layer was irradiated with UV-rays of 1500 mJ/cm², thereby to obtain a wiring board whose wiring pattern-bearing surface was covered with an insulating layer of the cured resin.

(5) Preparation of Multi-Layered Printed Wiring Board:

The insulating layer was applied with a full additive adhesive and the adhesive coat was dried. Through-holes were then formed by drilling and an electroless plating resist was screen printed. After curing of the resist, electroless plating was effected to form a wiring pattern. Thereafter, solder resist and marking ink were screen printed and cured to obtain a four-layered board printed wiring board.

Example 2

(1) Preparation of Photocurable Resin Composition:

A photocurable resin coating composition was prepared by mixing the following ingredients:

| Ingredients | Amount (parts by weight) |
|---|---|
| Epikote 1001 *1 | 400 |
| Eslec B BL-2 *5 | 100 |
| Epikote 828 *3 | 400 |
| Optomer SP-170 *4 | 40 |
| Methyl ethyl ketone | 400 |

*1, 3 and 4: the same as above
*5: Butyral resin, manufactured by Sekisui Kagaku Inc.

(2) Preparation of Laminate Film and Press Bonding:

Using the above composition, a rolled laminate film was prepared in the same manner as that in Example 1. With the use of the rolled laminate film, a wiring board whose wiring pattern-bearing surface was covered with the photocurable resin layer was prepared in the same manner as that in Example 1. The substrate film was not removed.

(3) Curing:

The photocurable resin layer was irradiated with UV-rays of 1500 mJ/cm$^2$ through a pattern film. The pattern film and the substrate film were removed and the unexposed area of the resin layer was removed by dissolution with trichloroethylene, thereby to obtain a wiring board having a desired pattern of the insulating layer of the cured resin.

(4) Electromagnetic Shielding:

The insulating layer was applied with a conductive paint (copper paint) with a portion of the coating being contacted with the ground conductor of the wiring board. The coating was then dried and hardened, over which a solder resist was provided.

## Claims

1. A laminate film comprising a substrate film and a photocurable resin film formed of a photocurable resin composition and supported on one surface of said substrate film, said composition including an epoxy resin, a photopolymerization catalyst and a polymer selected from the group consisting of phenoxy resins having a number average molecular weight of at least 10,000 and butyral resins having a number average molecular weight of at least 10,000, the amount of said polymer being 5-150 parts by weight per 100 parts by weight of said epoxy resin.

2. A laminate film according to claim 1, wherein said photocurable resin film is removably supported on said substrate film.

6

3. A laminate film according to claim 1, wherein said substrate film is an electrically conducting film.

4. A laminate film according to claim 2, further comprising an intermediate layer provided between said photocurable resin film and said substrate film and containing a releasing agent to improve the removability of said photocurable resin film from said substrate film.

5. A laminate film according to claim 4, further comprising a protecting layer peelably provided over said photocurable resin film.

6. A laminate film according to claim 5, further comprising a second intermediate layer provided between said protecting layer and said photocurable resin film to improve the peelability of said protecting layer.

7. A laminate film according to claim 6 wound in the form of a roll.

8. A laminate film according to claim 1, further comprising a protecting layer peelably provided over said photocurable resin film.

9. A laminate film according to claim 8, further comprising a second intermediate layer provided between said protecting layer and said photocurable resin film to improve the peelability of said protecting layer.

10. A laminate film according to claim 9 wound in the form of a roll.

11. A laminate film according to claim 1 wound in the form of a roll and further comprising an outer layer provided on the other side of said substrate film and containing a releasing agent to prevent sticking between the top surface of said photocurable resin film and the other side of said substrate film.

12. A laminate film according to claim 1, wherein said epoxy resin contains at least 30 % by weight of a solid epoxy resin having a number average molecular weight of at least 300.

EP 0 488 705 A1

| | **European Patent Office** | **EUROPEAN SEARCH REPORT** | | **Application Number** |
|---|---|---|---|---|

EP   91 31 0980

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | EP-A-0 381 899 (SOMAR CORPORATION) <br> * page 6, line 38 - line 47; example 5 * <br> --- | 1-12 | G03F7/038 <br> H05K3/00 |
| Y,D | EP-A-0 153 904 (CIBA-GEIGY AG) <br> * page 1, paragraph 3 * <br> * page 2, paragraph 1 * <br> * page 17, paragraph 2 * <br> ----- | 1-12 | |
| | | | **TECHNICAL FIELDS SEARCHED (Int. Cl.5)** |
| | | | G03F <br> H05K |

| The present search report has been drawn up for all claims | | |
|---|---|---|
| Place of search | Date of completion of the search | Examiner |
| THE HAGUE | 02 MARCH 1992 | DUPART J-M.B. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P0401)